# EUROPÄISCHE PATENTANMELDUNG

(11) **EP 2 256 229 A1**
(43) Veröffentlichungstag der Anmeldung: **01.12.2010**
(21) Anmeldenummer: 10173598.3
(22) Anmeldetag: 21.09.2006
(51) Int. Cl.: C23C 14/06, C23C 14/35, C23C 28/00

(54) **Schichtsystem zur Bildung einer Oberflächenschicht auf einer Oberfläche eines Substrats, Beschichtungsverfahren und Substrat mit einem Schichtsystem**

(30) Priorität: 04.11.2005 EP 05405620
(62) Teilanmeldung aus: 06121043.1
(71) Anmelder: Sulzer Metaplas GmbH, 51427 Bergisch-Gladbach (DE)
(72) Erfinder: Vetter, Jörg, Dr., 51469, Bergisch Gladbach (DE)

(57) **Zusammenfassung**

Die Erfindung betrifft ein Schichtsystem (1) zur Bildung einer Oberflächenschicht auf einer Oberfläche (2) eines Substrats (3), insbesondere auf der Oberfläche (2) eines Werkzeugs (3), wobei das Schichtsystem mindestens eine Hartschicht (4, 5, 6, 7, 8) der Zusammensetzung SiₐB_{b}Me_{c}NᵤCᵥO_{w} mit a,b > 0 und 33 at% > c ≥0, bevorzugt 25 at% > c ≥0, im Speziellen 10 at% > c ≥0 und u,v,w ≥ 0 umfasst, und Me ein Metall ist. Ferner betrifft die Erfindung ein Beschichtungsverfahren zum Aufbringen eines Schichtsystems (1), sowie ein Substrat (3), insbesondere ein Werkzeug (3) oder ein Verschleissteil (3) mit einem erfindungsgemässen Schichtsystem (1).

## Beschreibung

Die Erfindung betrifft eine Schichtsystem zur Bildung einer Oberfläche auf einem Substrat, ein Beschichtungsverfahren zum Aufbringen eines Schichtsystems, sowie ein Substrat, insbesondere ein Werkzeug mit einem erfindungsgemässen Schichtsystem gemäss dem Oberbegriff des unabhängigen Anspruchs der jeweiligen Kategorie.

Die Herstellung leistungsfähiger Werkzeuge und Bauteile wird meistens durch eine Beschichtung von deren Oberflächen realisiert. Eine wichtige Klasse solcher beschichteten Werkzeuge sind neben anderen insbesondere zerspanende Werkzeuge in allen möglichen Ausführungsformen. Typische Werkzeugmaterialien, die beschichtet werden, sind unter anderem Werkzeugstähle und Hartmetalle.

Ein bekanntes Problem beim Beschichten dieser Werkstoffe ist dabei, dass beide eine hohe Oxidationsrate an Luft bereits um 500 °C aufweisen und bereits bei relativ niedrigen Temperaturen (ca. HSS 550 °C, Hartmetall 650 °C) erweichen.

Daher kommen insbesondere für die Hartbearbeitung von Stählen bevorzugt auch keramische Schneidkörper, z.B. auf der Basis von kubischem Bornitrid zum Einsatz. So werden zum Beispiel zur Hochgeschwindigkeitsbearbeitung von Al-Legierungen und Grauguß vermehrt verschiedenste SiN-Keramiken eingesetzt. Die Keramiken erweisen sich dabei als wesentlich beständiger gegenüber den metallischen Werkzeugmaterialien. Eine weitere Leistungssteigerung kann durch geeignete Beschichtung der Werkzeuge erreicht werden.

Die aus dem Stand der Technik bekannten Hartstoffschichten basieren dabei häufig auf klassischen Verbindungen wie TiN, TiNC, CrN. Diese bekannten Hartschichten haben in Bezug auf ihren Einsatzbereich aufgrund ihrer speziellen physikalischen Eigenschaften jedoch ihre Grenzen, vor allem bezüglich der Temperaturbelastbarkeit. Einerseits sinkt nämlich die Härte bei erhöhten Temperaturen merklich ab, andererseits setzt bereits bei relativ niedrigen Temperaturen eine Oxidation ein, die zu erhöhtem Schichtverschleiß bei der Einsatztemperatur führen kann.

Um diese Probleme zu umgehen wurden im wesentlichen zwei Schichtklassen entwickelt, die eine Oxidationsbeständigkeit im Bereich bis zu 1000 °C aufweisen und auch bezüglich der Härte verbesserte Eigenschaften haben.

Die eine Schichtklasse betrifft Al-haltige Basisschichten wie AlTiN und AlCrN, wobei, je nach Anforderung zusätzliche Elemente hinzulegiert werden können. Typische Verbindungen aus diesem Bereich sind Verbindungen der Form AlTiXNCO, wobei X z.B. Cr oder ein anderes Metall ist.

Ein anderer im Stand der Technik beschrittener Weg zur Leistungssteigerung beschichteter Werkzeuge besteht in der Kombination von klassischen Hartstoffschichten als Trägerschicht kombiniert mit Finish-Schichten als Funktionsschicht. Insbesondere sind hier als Finish-Schichten die hoch Sihaltigen Schichten (10 at% oder mehr; at% bedeutet dabei im Rahmen dieser Anmeldung "Atomprozent") des Typs MeSiXNCO-Schicht (X weitere Metalle oder B) wie TiSiN zu nennen, die eine deutlich verbesserte Temperaturbelastung ermöglichen.

Daneben ist es weiterhin beispielsweise bekannt, oxidische Keramikschichen wie Al₂O₃ mittels CVD-Verfahren auf Wendeschneidplatten abzuscheiden, um den Verschleißprozessen bei erhöhten Kontakttemperaturen, insbesondere beim Drehen begegnen zu können.

Im Stadium der Erforschungen sind darüber hinaus Bor-basierte Schichten, wie zum Beispiel B₄C oder auch kubische BN Schichten. Allerdings hat kubisches BN den entscheidenden Nachteil, dass es äußert kompliziert darstellbar ist. Dies ist vor allem durch Schwierigkeiten beim Schichtwachstum selbst, aber auch durch die hohen Eigenspannungen in den Schichten bedingt.

Im Bereich der Hochtemperaturwerkstoffe wurden in den letzten Jahren Volumenkeramiken auf der Basis von SiCN erzeugt, die sich durch hohe Härten und eine Verbesserung der Oxidationsbeständigkeit gegenüber SiC und Si₃N₄ auszeichnen. Deren besondere Eigenschaften sind durch die komplexen kovalenten chemischen Bindungen und die niedrige Diffusionsrate von Sauerstoff in der amorphen Struktur des SiCN begründet.

Allen bisherigen Bemühungen zum Trotz ist es aber nur teilweise gelungen, Beschichtungen zur Verfügung zu stellen, die den immer höheren Anforderungen an die mechanischen Eigenschaften, wie zum Beispiel Härte und Zähigkeit, tribologische Eigenschaften wie Adhäsionsneigung bei höheren Temperaturen sowie Reibung, die Oxidationsresistenz und anderen charakteristischen Eigenschaften, vor allem auch bei extremen Temperaturen gerecht zu werden.

Ausserdem sind die oben beschriebenen leistungsfähigeren Schichten verfahrenstechnisch sehr schwer herstellbar, so dass die damit beschichteten Werkzeuge sehr teuer sind, so dass sich vom Standpunkt der Wirtschaftlichkeit betrachtet, eine Beschichtung in vielen Fällen nicht lohnt, bzw. solcherart beschichtete Werkzeuge nur einen begrenzten Markt finden.

Die Aufgabe der Erfindung ist es daher, eine verbesserte Beschichtungen für ein Substrat, insbesondere für ein Werkzeug bereitzustellen, die die aus dem Stand der Technik bekannten Probleme überwindet, und insbesondere ein sich tribologisch positiv auswirkendes Oxidationsverhalten, verbesserte mechanische Eigenschaften, vor allem, aber nicht nur, in Bezug auf die Härte aufweist und auch unter extremen Temperaturbedingungen einsetzbar ist.

Eine weitere Aufgabe der Erfindung ist es, ein Verfahren anzugeben, mit welchem die erfindungsgemässen Schichten besonders zuverlässig und einfach auf ein Substrat aufgebracht werden können, wobei möglichst auf aus dem Stand der Technik bereits bekannte Beschichtungsapparaturen zurückgegriffen werden kann, so dass auch der Beschichtungsvorgang selbst besonders wirtschaftlich bewerkstelligt werden kann.

Die diese Aufgaben lösenden Gegenstände der Erfindung sind durch die Merkmale des unabhängigen Anspruchs der jeweiligen Kategorie gekennzeichnet.

Die jeweiligen abhängigen Ansprüche beziehen sich auf besonders vorteilhafte Ausführungsformen der Erfindung.

Die Erfindung betrifft somit ein Schichtsystem zur Bildung einer Oberflächenschicht auf einer Oberfläche eines Substrats, insbesondere auf der Oberfläche eines Werkzeugs, wobei das Schichtsystem mindestens eine Hartschicht der Zusammensetzung SiₐB_{b}Me_{c}NᵤCᵥO_{w} mit a,b > 0 und 33 at% > c ≥ 0, u,v,w ≥ 0 umfasst, und Me ein Metall ist.

Im speziellen gilt 25 at% > c ≥ 0, insbesondere 10 at% > c ≥ 0.

Die gegenüber dem Stand der Technik erheblich verbesserte Leistungsfähigkeit der Werkzeuge und Bauteile wird somit erfindungsgemäss durch die Verwendung von SiB-Schichten erzielt.

Erfindungsgemäss wird somit vorgeschlagen, den Anteil der metallischen Komponenten der Schichten zu minimieren bzw. ganz zu eliminieren, so dass Si/B dominierende Schichten eingesetzt werden.

Bedingt durch die komplizierte Herstellung von SiBx Keramiken ist darüber relativ wenig bekannt. Es liegen folgende Angaben für SiB₆ Volumenmaterialien vor orthorhombisches Gitter, Härte ca. 2600 , Elastizitätsmodul 290 GPa, Dichte 2,43 g/cm³, thermischer Ausdehnungskoeffizient 4,6 *10⁻⁶/ °C, Wärmeleitfähigkeit 9 W/mK, Schmelzpunkt 1950 °C. Insbesondere ist die hohe Oxidationsbeständigkeit hervorzuheben: stabil in Luft bis 1550 °C.

Diese Stabilität bei hohen Temperaturen wird von den klassischen Schichtsystemen wie AlTiN, AlCrSiN und TiSiN nicht erreicht.

Diese Volumeneigenschaften sind in ähnlicher Form bei Schichten des Typs SiBx hinsichtliche der Härten und der Oxidationseigenschaften zu finden. wobei die Darstellung dieser Schichten mittels der PVD-Beschichtung industrielle Relevanz hat.

Der Mechanismus des Oxidationsschutzes der SiBx-Schichten beruht dabei auf der Ausbildung einer Doppelschicht des Types SiO/BO. Die entstehende äußere Si-reiche Schicht verhindert die Sauerstoffdiffusion in die Schicht.

Somit wird erfindungsgemäss vorgeschlagen, die neue Beschichtungs-Materialklasse SiBx, insbesondere speziell die neue Beschichtungs-Materialklasse SiBCN als Beschichtungsmaterial für Werkzeuge einzusetzen.

Dabei hat sich ausserdem überraschend gezeigt, dass eine Beschichtung auf der Basis von SiB-Verbindungen, bzw. von SiBNC in Kombination mit den bekannten klassischen Hartstoffschichten ebenfalls zu den deutlich verbesserten Schichteigenschaften führt.

Je nach Anforderung an die zu beschichtenden Substrate bzw. Werkzeuge kann es im Speziellen besonders vorteilhaft sein, die Schichten mit Sauerstoff zu dotieren, und so zum Beispiel zu SiBNCO-Schichten zu gelangen, die unter anderem durch Voroxidation bzw. durch Verfeinerung der Struktur der Schichten die Diffusion von Sauerstoff reduzieren und die Oxidationsbeständigkeit auch bei hohen Temperaturen massiv erhöhen.

Die Dotierung mit Sauerstoff führt darüber hinaus zu einer Belegung der Korngrenzen mit Sauerstoff, so dass zumindest bei einer partiellen Ausbildung der oben genannten oder anderer Doppelschichtsysteme die Neigung zu Strukturumwandlung in den Schichtsystemen, die oftmals eine mehr oder weniger offene Porosität bzw. Schichtdefekte aufweisen, reduziert wird, da durch die Dotierung mit Sauerstoff eine Voroxidation eingeleitet wird.

Gemäss der vorliegenden Erfindung ist es dabei entscheidend, dass die Schichten mindestens die beiden Elemente Si und B aufweisen, um das erfindungsgemässe Schichtsystem zu bilden, insbesondere um die schützenden Doppelschichten ausbilden zu können. Das heisst, das erfindungsgemässe Schichtsystem umfasst mindestens eine Hartschicht der Zusammensetzung SiₐB_{b}Me_{c}NᵤCᵥO_{w} mit a,b > 0 und 33at% > c ≥ 0 und u,v,w ≥ 0,wobei Me ein Metall ist, dass im Speziellen z.B. ein für die Targetherstellung zur Abscheidung der erfindungsgemäßen Schicht verwendetes Metall z.B. Al bei SiC, oder aber ein gezielt eingebautes metallisches Element sein kann.

Die Schichten eines erfindungsgemässen Schichtsystems können dabei vorzugsweise auf geeigneten metallischen Zwischenschichten aber auch auf Si, SiC Zwischenschichten sowie direkt auf metallischen oder keramischen Werkzeugmaterialien oder vorzugsweise auf mit Hartstoffschichten beschichteten Werkzeugmaterialien abgeschieden werden.

Bevorzugt, aber nicht notwendig, liegen die Schichten eines erfindungsgemässen Schichtsystems in einem weitgehend amorphen Zustand vor, wobei in einem speziellen Ausführungsbeispiel eine Ausbildung von nanokristallinen Bereichen in den Schichten vorliegt.

Die Schichtdicken liegen dabei im Bereich zwischen ca. 5 nm - 50 000 nm, im Speziellen zwischen 10 nm und 2500 nm, vorzugsweise zwischen (100 - 500) nm und können als Unterschicht z.B. Al-Basishartstoffschichten abgeschieden in gleichen oder in getrennten Anlagen umfassen.

Die metallische Komponente Me des erfindungsgemässen Schichtsystems ist dabei mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm.

Bei einem besonders bevorzugten Ausführungsbeispiel ist auf der Oberfläche des Substrats mindestens eine Verbundschicht, bevorzugt eine Verbundschicht aus MeₓEyN_{z}, mit x,y ≥ 0 und z > 0 vorgesehen, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm und E ein Element aus der Gruppe bestehend aus Si, B, C, O ist.

Für spezielle Anwendungen kann ein spezielles erfindungsgemässes Schichtsystem auch eine erste Hartschicht aus SiₐB_{b}Me_{c}NᵤCᵥO_{w}, insbesondere eine erste Hartschicht aus SiₐB_{b}Me_{c}CᵥNᵤ, im speziellen eine Hartschicht aus SiₐB_{b}CᵥNᵤ vorgesehen sein.

In einem besonders bevorzugten Ausführungsbeispiel ist eine AlTi-Hartschicht vorgesehen, die zum Beispiel die erste Hartschicht und / oder eine andere Hartschicht sein kann, mit der Zusammensetzung (Al_{1-α-β}Ti_{α}X_{β}) (N₁₋γCγO_{δ}B_{ε}), mit 0.2 < α < 0.6, 0 ≤ β < 0.2 und α+β > 0.01 und 0 ≤ γ < 0.5, 0 ≤ δ < 0.5, 0 ≤ε < 0.5 und γ+δ+ε > 0.01, wobei X ein Element der Gruppe bestehend aus Zr, V, Cr, Nb, Ta; W; Mo; Hf, Mg Si, Y ist.

Die Schichten auf der Basis von SiB werden im Bereich der atomaren Zusammensetzung von Si:B im Bereich von 9 bis 0.1 abgeschieden, wobei die verschiedensten Zusammensetzungen innerhalb einer Gradientenschicht bzw. mehrlagigen Schicht darstellbar sind. Bevorzugt werden Bor-reiche Schichen abgeschieden, d. h: der Si Gehalt ist kleiner als der Borgehalt. Insbesondere ist die Zusammensetzung mit 6 Boaratomen pro Si-Atom interessant, da sich zumindest lokal die besonders stabile SiB6-Struktur in den Schichten ausbilden kann.

Die Zuführung von N,C;O führt zur Ausbildung verschiedenster Bindungszustände in den Schichten, so treten B-N, B-C, Si-N ,Si-C, Si-O, B-O Bindungen auf, die sich jedoch nur aufwendig quantifizieren lassen. Die kovalenten Bindungsanteile (z.B SiN und BC) bewirken eine hohe Härte. Der strukturelle Mechanismus und der Bindungsmechanismus dieser komplexen Schichten ist beim gegenwärtigen Stand des Wissens nur unzureichend, um Voraussagen über die komplexen Schichteigenschaften zu treffen.

In einer bevorzugten Ausführungsform sollte die atomare Zusammensetzung der Schichtenten im Verhältnis aus ca. gleichen Anteilen von Si und Bor und N bzw. Mischungen aus N,C,O bestehen. Es ist aber auch eine überstöchiometrische Zusammensetzung hinsichtlich des N und C-Gehaltes bezogen auf SiB anstrebenswert, die jedoch herstelltechnisch problematisch ist. Beispielsweise wäre eine solche Schichtzusammensetzung ca. gleiche Anteile von Si, B und C jedoch ca. einen N-Anteil, der das dreifache des Si-Anteiles beträgt entsprechend der Volumenkeramiken sinnvoll.

Bei den oben beschriebenen bevorzugten Zusammensetzungen können zumindest lokal sich hochstabile Verbindungen ausbilden - in Form von Si₃B₃N₇ oder SiBN₃C. Im Gegensatz zu den Keramiken diesen Types handelt es sich naturgemäß bei den PVD-Schichten um Schichten, die PVD spezifische Strukturen wie z.B Wachstumsdefekte, Wachstumsstrukturen sowie Wachstumseigenspannungen aufweisen.

Die Sauerstoffgehalte in den Schichten werden deutlich unter 50 at% vorzugsweise um 10 at% bezogen auf die Gesamtzusammensetzung begrenzt, da der ionische Bindungsanteil, der in der Regel zu sprödem Materialverhalten führt begrenzt werden sollte.

Metallanteile in den Schichten werden sinnvoll ebenfalls mit deutlich unter 50 at% eingestellt, wobei diese meist - außer in den Zwischenschichten - auf maximal 10 At% beschränkt sind. Diese Anteile dienen dabei als Bindungsbrücken zur untereren Hartstoffschicht bzw. entstammen aus den Targetbindemitteln.

Die Härten der Schichten überstreichen dabei den Bereich von ca. 1000 bis 5000 Vickers, bevorzugt zwischen 2000 und 3500 Vickers. Die Auswahl der geeigneten Schicht richtet sich dabei nach den jeweiligen tribologischen Eigenschaften. Beispielsweise ist für verschiedene Mikrowerkzeuge die Reibung aussschlagebend, um Überhitzungen zu vermeiden, so dass reibungsminderene Boroxide wünschenswert sind, wobei schon Schichthärten um 1000 Vickers sinnvoll sein können. Es kommt auf eine tribologische Trennschicht an. In Anwesenheit von Luftfeuchtigkeit wandelt sich das Boroxid zu Borsäure um, wodurch niedrige Reibwerte erreichbar sind.

Bei Kugelfräsern im Kontakt zu Ti-Legierungen sollte hingegen ein hohes Härteniveau eingestellt werden.

Nicht nur, aber auch zur Verbesserung der Hafteigenschaften auf dem Substrat, zum Beispiel auf einem besonders stark beanspruchten Werkzeug, kann zwischen dem Substrat und der Hartschicht und / oder zwischen der Verbundschicht und der Hartschicht und / oder zwischen der ersten Hartschicht und der Hartschicht eine Zwischenschicht umfassend die Elemente Si und / oder C vorgesehen sein.

Darüber hinaus kann in einem weiteren Ausführungsbeispiel zwischen dem Substrat und der Hartschicht und / oder zwischen der Verbundschicht und der ersten Hartschicht und / oder zwischen der ersten Hartschicht und der Hartschicht eine Gradienten-Mischschicht vorgesehen sein, die die Elemente Si und / oder C der Zwischenschicht und die Zusammensetzung SiₐB_{b}Me_{c}NᵤeᵥO_{w}, insbesondere SiₐB_{b}Me_{c}eᵥNᵤ, im speziellen SiₐB_{b}CᵥNᵤ der ersten Hartschicht umfasst. Die Zusammensetzung der Gradienten-Mischschicht ändert sich dabei mehr oder weniger kontinuierlich von der Zusammensetzung einer ersten Schicht, mit der die Gradienten-Mischschicht in Kontakt ist, zu der Zusammensetzung einer zweiten Schicht, mit der die Gradienten-Mischschicht ebenfalls in Kontakt ist, so dass die erste und die zweite Schicht, die zum Beispiel verschiedene chemische und / oder physikalische Eigenschaften, wie Gitterstruktur, Kristallinität, thermische Ausdehnung usw. haben können, optimal aufeinder anpassbar.

Besonders vorteilhaft ist eine Sauerstoff-Hartschicht aus SiₐB_{b}MₑNᵤCᵥO_{w}, im speziellen eine SiₐB_{b}NᵤCᵥO_{w} Sauerstoff-Hartstoffschicht vorgesehen, die insbesondere als Deckschicht vorgesehen sein kann. Diese Deckschicht kann zum Beispiel, aber nicht nur die Diffusion von Sauerstoff in die Schicht unterbinden oder minimieren, dadurch unter anderem die Oxidationsfestigkeit erhöhen. Ausserdem kann die Deckschicht dem Schichtsystem gegen Angriffe von aussen, besondere chemische, thermische und mechanische Eigenschaften verleihen, so dass das Schichtsystem durch die Deckschicht zum Beispiel besonders gut gegen die hohe Temperatur geschützt ist und / oder besonders vorteilhafte mechanische Eigenschaften, oder besonders gute tribologische Eigenschaften aufweisen.

Die Schichtdicke der Verbundschicht und / oder der Zwischenschicht und/ oder der Hartschicht und / oder der ersten Hartschicht und / oder der Gradienten-Mischschicht und / oder der Sauerstoff-Hartstoffschicht und / oder der Deckschicht liegen dabei bevorzugt zwischen 5 nm und 50000 nm, vor allem zwischen 10 nm und 5000 nm, im besonderen zwischen ca. 50 nm - 5 000 nm, vorzugsweise zwischen 100 nm- 500nm, Speziellen zwischen 80 nm und 600 nm.

Die Schichtdicke der Verbundschicht liegt bevorzugt zwischen 100 nm und 50 000 nm, im besonderen zwischen 100 nm und 3000 nm, die Schichtdicke der ersten Hartschicht zwischen 100 nm und 3000 nm, bevorzugt zwischen 400 nm und 600 nm, die Schichtdicke der Zwischenschicht und / oder der Gradienten-Mischschicht zwischen 20 nm und 500 nm, bevorzugt zwischen 50 nm und 120 nm und eine Schichtdicke der Sauerstoff- Hartschicht zwischen 10 nm und 100 nm, bevorzugt zwischen 40 nm und 60 nm.

Es versteht sich, dass die zuvor beschriebenen Ausführungsbeispiele der Erfindung, je nach Anwendung, auch in jeder geeigneten Weise kombinierbar sind und insbesondere die exemplarisch dargestellten Schichtabfolgen auch in anderer Weise realisiert sein können und eine oder mehrere der Schichten in einem speziellen Ausführungsbeispiel eines erfindungsgemässen Schichtsystems ganz fehlen können oder in einem anderen Ausführungsbeispiel in ein und demselben Schichtsystem auch mehrfach vorkommen können.

Die Erfindung betrifft weiter ein Beschichtungsverfahren zum Aufbringen eines Schichtsystems der Art, wie sie oben eingehend beschrieben wurden, auf eine Oberfläche eines Substrats, insbesondere auf ein Werkzeug, in einer Prozesskammer einer Beschichtungsvorrichtung. Die Beschichtungsvorrichtung umfasst eine RF-Beschichtungsquelle mit einem RF-Magnetron und / oder einer DC-Beschichtungsquelle, insbesondere mit einem DC-Magnetron oder einem Vakuum Bogenverdampfer, wobei die RF-Beschichtungsquelle und / oder die DC-Beschichtungsquelle durch eine Blende verschlossen werden kann, und Mittel vorgesehen sind, so dass der Prozesskammer ein Prozessgas zuführbar ist. Das erfindungsgemässe Verfahren umfasst dabei die Verfahrensschritte: Einbringen des Substrats in die Prozesskammer; Erhitzen des Substrats auf eine Ionenreinigungstemperatur, Ionenereinigung des Substrats bei der Ionenreinigungstemperatur, Abscheidung eines Schichtsystems der Zusammensetzung SiₐB_{b}Me_{c}NᵤCᵥO_{w} mit a,b > 0 und 33 at% > c ≥ 0 und u,v,w ≥ 0, wobei Me ein Metall ist, unter Verwendung der RF-Beschichtungsquelle und / oder der DC-Beschichtungsquelle

Im speziellen gilt 25 at% > c ≥ 0, insbesondere 10 at% > c ≥ 0.

Speziell kann dabei gelten a+b+c = 100%, was einerseits bedeuten kann, dass eine Schicht eines erfindungsgemässen Schichtsystems z.B. nur Si, B und eine Metall enthält.

In einem anderen Beispiel kann die Aussage a+b+c = 100% aber auch bedeuten, dass eine Zählweise für den Anteil der in der Verbindung SiₐB_{b}MₑcNᵤCᵥO_{w} enthaltenen Elemente gewählt ist, die die beiden Elementgruppen (SiₐB_{b}Me_{c}) und (NᵤCᵥO_{w}) getrennt in der Weise zählt, dass die beiden Summen (a+b+c) und (u+v+w) jeweils getrennt 100% ergeben, wobei, wie erwähnt, die Elemente N und / oder C und / oder O auch ganz fehlen können. Ein Beispiel für die zuvor eingeführte Zählweise zur Angabe einer Zusammensetzung wäre etwa Si_{0.3}B_{0.6}Cr_{0.1}N_{0.2} C_{0.5}O₀.₃. Das heisst, die Angabe der Zusammensetzung erfolgt derart, dass Si, B und Me (hier Cr) zusammen 100% ergeben und die zweite Element-Gruppe N, C und O sich ebenfalls zu 100% addieren.

In einem für die Praxis besonders wichtigen Ausführungsbeispiel umfasst das Beschichtungsverfahren die folgenden Verfahrensschritte: Einbringen des Substrats in die Prozesskammer; Erhitzen des Substrats auf eine Ionenreinigungstemperatur; Ionenereinigung des Substrats bei der Ionenreinigungstemperatur und Anlegen einer Bias Gleichspannung und / oder einer RF-Spannung an das Substrat zur Ionenreinigung; Öffnen der Blende der DC-Beschichtungsquelle und / oder der Blende einer ersten RF-Beschichtungsquelle; Abscheiden einer Verbundschicht auf der Oberfläche des Substrats, insbesondere einer Verbundschicht aus MeₓEyN_{z}, mit x,y ≥ 0 und z > 0, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist, und E ein Element aus der Gruppe Si, B, C, O ist; Deaktivieren der DC-Beschichtungsquelle und / oder der ersten RF-Beschichtungsquelle, Öffnen einer Blende einer zweiten RF-Beschichtungsquelle und in Betriebnahme der zweiten RF-Beschichtungsquelle; Abscheiden einer Zwischenschicht umfassend die Elemente Si und / oder C mittels der zweiten RF-Beschichtungsquelle; Öffnen einer Blende einer dritten RF-Beschichtungsquelle, in Betriebnahme der dritten RF-Beschichtungsquelle und im Parallebetrieb mit der zweiten RF-Beschichtungsquelle Abscheidung von SiₐB_{b}Me_{c}NᵤCᵥO_{w}, insbesondere von SiₐB_{b}Me_{c}CᵥNᵤ, im speziellen von SiₐB_{b}CᵥNᵤ der ersten Hartschicht mittels der zweiten RF-Beschichtungsquelle zur Bildung einer Gradienten-Mischschicht; Deaktivieren der zweiten RF-Beschichtungsquelle und Abscheiden einer ersten Hartschicht aus SiₐB_{b}Me_{c}NᵤCᵥO_{w}, insbesondere SiₐB_{b}Me_{c}CᵥNᵤ im speziellen SiₐB_{b}CᵥNᵤ beim Weiterbetrieb der dritten RF-Beschichtungsquelle bis zu einer vorgegebenen Beschichtungsdicke der ersten Hartschicht; Zugabe eines Reaktivgases, insbesondere Sauerstoff, Stickstoff oder ein Kohlenstoff enthaltendes Gas, in die Prozesskammer und Bildung einer Sauerstoff-Hartschicht mit der Zusammensetzung SiₐB_{b}Me_{c}NᵤCᵥO_{w}.

In einem besonders bevorzugten Ausführungsbeispiel ist die DC-Beschichtungsquelle und / oder die RF-Beschichtungsquelle eine Sputterquelle und / oder eine Lichtbogen-Verdampfungsquelle ist.

Der Beschichtungsvorgang selbst kann gemäss einem erfindungsgemässen Verfahren mittels eines PVD-Verfahrens, bevorzugt mittels RF-Sputtern und / oder DC-Sputtern und / oder mittels eines CVD-Verfahrens, bevorzugt mittels PE-CVD und oder Laser-CVD, und / oder mittels Laserablation und /oder mittels einem Lichtbogenverdampfungsverfahren, insbesondere mittels einem kathodischen und / oder anodischen Lichbogenverdampfungsverfahren durchgeführt werden.

Bevorzugt, aber nicht notwendig, wird dabei diejenige Schicht des Schichtsystems, die unmittelbar auf der Oberfläche des Substrats, zum Beispiel unmittelbar auf der Oberfläche eines Werkzeugs abgeschieden wird, mittels eines Lichbogen-Verdampfungsverfahrens, z.B. durch anodische und / oder kathodische Lichtbogenverdampfung aufgebracht.

In einem speziellen Ausführungsbeispiel eines erfindungsgemässen Beschichtungsverfahrens wird nach der Ionenreinigung des Substrats und vor der Abscheidung der Hartschicht, eine Verbundschicht, insbesondere eine Verbundschicht aus AlₓCr_{y}N_{z}, mit x,y,z ≥ 0, auf der Oberfläche des Substrats, und zwar bevorzugt mit der DC-Beschichtungsquelle abgeschieden.

In einem anderen Ausführungsbeispiel wird zwischen einer ersten Hartschicht aus SiₐB_{b}MeCᵥNᵤ, insbesondere aus SiₐB_{b}CᵥNᵤ und dem Substrat und / oder zwischen der Verbundschicht und der ersten Hartschicht, eine Zwischenschicht umfassend die Elemente Si und / oder C abgeschieden.

In einem weiteren Ausführungsbeispiel wird zwischen dem Substrat und der Hartschicht und / oder zwischen der Verbundschicht und der ersten Hartschicht eine Gradienten-Mischschicht abgeschieden wird, die die Elemente Si und C der Zwischenschicht und die Zusammensetzung SiₐB_{b}MeCᵥNᵤ, insbesondere SiₐB_{b}CᵥNᵤ der ersten Hartschicht umfasst.

Dabei kann in einem anderen für die Praxis besonders wichtigen Ausführungsbeispiel eines erfindungsgemässen Verfahrens auf die Verbundschicht und / oder auf die erste Hartschicht und / oder auf die Zwischenschicht und / oder auf eine Sauerstoff-Hartschicht, eine Sauerstoff-Hartschicht aus SiₐB_{b}MeNᵤCᵥO_{w}, im Speziellen eine Sauerstoff-Hartschicht aus SiₐB_{b}NᵤCᵥO_{w} als Deckschicht auf dem Substrat abgeschieden werden.

In einem ganz speziellen Ausführungsbeispiel kann zwischen zwei Schichten des Schichtsystems, also zum Beispiel zwischen dem Substrat und der Verbundschicht und / oder zwischen der Verbundschicht und der Zwischenschicht und / oder zwischen der Zwischenschicht und der Hartschicht und / oder zwischen der Hartschicht und der Deckschicht und / oder zwischen zwei andren Schichten eines erfindungsgemässen Schichtsystems eine metallische Zwischenschicht, z.B. eine Chrom, Aluminium oder eine andere metallische Zwischenschicht als Bindeschicht zur besseren Verbindung zweier Schichten vorgesehen sein, wobei eine solche metallische Zwischenschicht unter anderem auch dazu beitragen kann, Eigenspannungen in bzw. zwischen zwei aufeinander folgenden Schichten abzubauen.

Die Ionenreinigungstemperatur bei einem erfindungsgemässen Verfahren liegt dabei bevorzugt zwischen 100°C und 1000°C, im Speziellen zwischen 250°C und 800°C liegt und die Ionenreiningung wird vorzugsweise, aber nicht notwendig, mit gepulster Vorspannung des Substrats durchgeführt. Ebenso kann während der Bildung der Zwischenschicht und / oder der Gradienten-Mischschicht an das Substrat eine elektrische RF-Spannung angelegt werden. Es versteht sich, dass die zuvor diskutierten Ausführungsvarianten von erfindungsgemässen Verfahren lediglich exemplarisch zu verstehen sind, und insbesondere im speziellen Fall die vorgestellten Verfahren auch in jeder geeigneten Weise kombiniert werden können.

Die Erfindung betrifft weiterhin ein Substrat, insbesondere Werkzeug, mit einem erfindungsgemässen Schichtsystem und / oder das mit einem erfindungsgemässen Verfahren aufgebracht wurde.

Das Werkzeug kann dabei unter anderem ein spanendes Werkzeug, insbesondere ein Bohrer, ein Fräser, eine Wendeschneidplatte für einen Dreh- oder Fräsprozess, ein Hobelwerkzeug, ein Umformwerkzeug oder ein Mikrowerkzeug, insbesondere ein Mikrobohrer, eine Mikrowendeschneidplatte, ein Mikrofräser oder ein anderes Werkzeug oder ein anderes Mikrowerkzeug oder ein Kunststoffwerkzeug sein.

Selbstverständlich kann die erfindungsgemässe Schicht auch besonders vorteilhaft auf ein Verschleissteil, insbesondere ein Verschleissteil für eine Luft- oder Land gestützte Turbine, einen Motor, im Speziellen für einen Verbrennungsmotor, im speziellen auf eine Dichtung, ein Zahnrad, einen Kolben oder auf ein anderes Verschleissteil als Beschichtung aufgebracht werden.

Im folgenden wird die Erfindung an Hand der schematischen Zeichnung näher erläutert. Es zeigen:
- Fig. 1: ein erfindungsgemässes Schichtsystem;
- Fig. 2: eine Beschichtungsvorrichtung zur Durchführung des erfindungsgemässen Verfahrens.

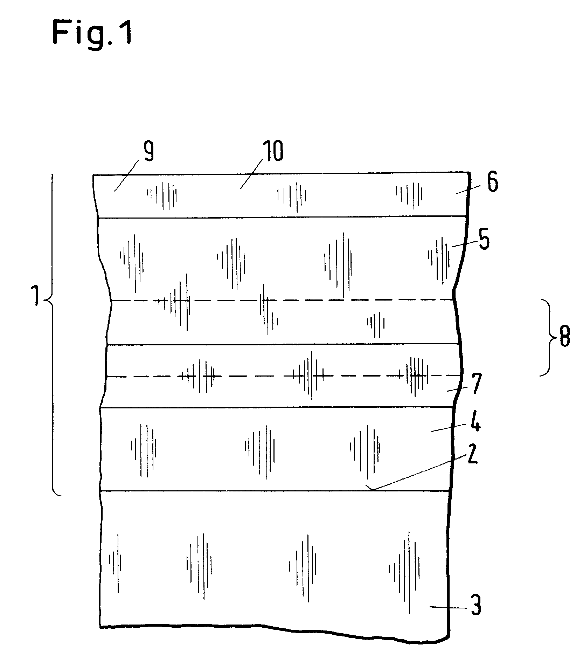

In Fig. 1 ist schematisch ein erfindungsgemäßes Schichtsystem dargestellt, das im folgenden gesamthaft mit dem Bezugszeichen 1 bezeichnet wird.

Auf dem Substrat 3, das zum Beispiel ein zerspanendes Werkzeug 3 sein kann, ist eine Verbundschicht 4 aufgebracht. Im vorliegenden Ausführungsbeispiel ist die Verbundschicht 4 eine Verbundschicht 4 aus MeₓE_{y}N_{z}, mit x,y ≥ 0 und z > 0, wobei Me mindestens ein Metall aus der Gruppe Al, Cr, Mo, W, Sc, Y, La, Ti, Zr, Hf, V, Nb, Ta, Mn, Tc, Re, Fe, Co Ni, Li, Ce ist und E ein Element aus der Gruppe Si, B, C, O ist. Speziell ist die Verbundschicht 4 eine AlCrN-Schicht und hat eine Dicke von ca. 2500 nm.

Auf die Verbundschicht 4 ist eine SiC Zwischenschicht 7 aufgebracht, die zum Beispiel eine Dicke von ca. 100 nm hat, und auf die Zwischenschicht 7 folgt dabei eine erste Hartschicht 5, die im vorliegenden Beispiel eine Dicke von ungefähr 500 nm aufweist. Die erste Hartschicht 5 ist eine SiₐB_{b}Me_{c}NᵤCᵥO_{w} Hartschicht 5, insbesondere eine erste Hartschicht 5 aus SiₐB_{b}Me_{c}eᵥNᵤ, im speziellen eine Hartschicht 5 aus SiₐB_{b}CᵥNᵤ, mit a,b > 0 und 33 at% > c ≥0 und u,v,w ≥ 0, und wobei Me ein Metall ist. Bei dem in Fig. 1 dargestellten speziellen Fall ist die erste Hartschicht 5 beispielsweise eine SiBCN Hartschicht 5.

In einem speziellen Beispiel eines Schichtsystems gemäss Fig. 1 kann die Verbundschicht eine Dicke von 20nm - 50000nm, die Zwischenschicht eine Dicke von 10nm - 1000nm, die Hartschicht eine Dicke von 100nm - 5000nm und die Deckschicht eine Dicke zwischen 5nm und 500nm aufweisen.

Bevorzugt hat dabei die Verbundschicht eine Dicke von 100nm - 2500nm, die Zwischenschicht eine Dicke von 20nm - 500nm, die Hartschicht eine Dicke von 100nm - 2500nm und die Deckschicht eine Dicke zwischen 10nm und 50nm.

Der Übergang zwischen der SiC Zwischenschicht 7 und der ersten Hartschicht 5 erfolgt über eine Gradienten-Mischschicht 8. Die Gradienten-Mischschicht 8 umfasst die Elemente Si und / oder C der Zwischenschicht 7 und die Zusammensetzung SiₐB_{b}Me_{c}NᵤCᵥO_{w}, insbesondere SiₐB_{b}Me_{c}CᵥNᵤ, im speziellen SiₐB_{b}CᵥNᵤ der ersten Hartschicht 5, so dass ein mehr oder weniger kontinuierlicher Übergang von der Zusammensetzung der Zwischenschicht 7 zur ersten Hartschicht 5, um umgekehrt, gewährleistet ist.

Als abschliessende Deckschicht 10 ist eine Sauerstoff-Hartschicht 9 aus SiₐB_{b}MeNᵤCᵥO_{w}, im speziellen eine SiₐB_{b}NᵤCᵥO_{w} Sauerstoff-Hartstoffschicht 9 vorgesehen, die das Schichtsystem 1 zur äusseren Umgebung abschliesst.

Dabei kann in einem speziellen Ausführungsbeispiel die Deckschicht 10 auch als Hartschicht 6 ausgebildet sein.

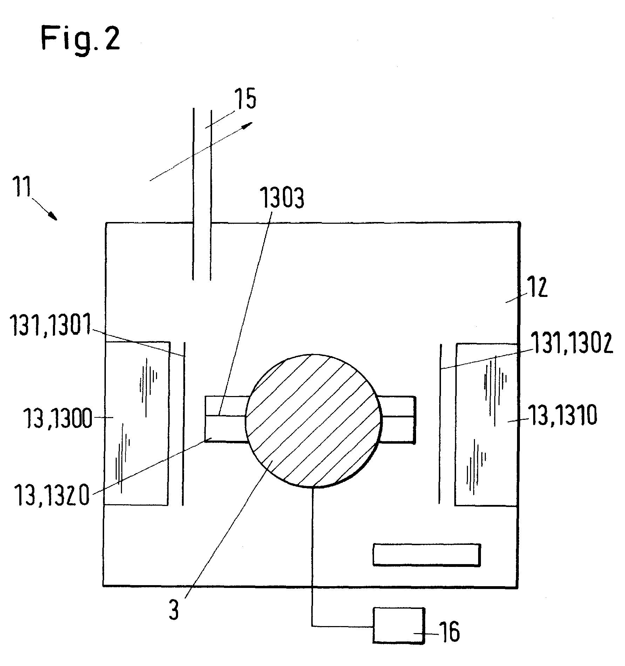

In Fig.2 ist schematisch der Aufbau einer Beschichtungsvorrichtung 11 dargestellt, die sich besonders vorteilhaft zur Durchführung des erfindungsgemässen Beschichtungsverfahrens eignet. Die an sich bekannte Beschichtungsvorrichtung 11 umfasst die Prozesskammer 12, in welcher Prozesskammer 12 bei der in Fig. 2 dargestellten speziellen Beschichtungsvorrichtung 11 drei verschiedene Beschichtungsquellen vorgesehen sind, nämlich die beiden RF-Beschichtungsquellen 1300 und 1310, die jeweils an einer darstellunggemäss rechten und linken Prozesskammerwand vorgesehen sind, und die DC-Beschichtungsquelle 13, 1320, die einer Rückwand der Prozesskammer 12 angeordnet ist. Alle Beschichtungsquellen 1300, 1310, 1320 besitzen jeweils eine Blende 131, mit der jede der Beschichtungsquellen 1300, 1310, 1320 separat und unabhängig voneinander abschirmbar sind, so dass dadurch z.B. die entsprechende Beschichtungsquelle für den Beschichtungsvorgang deaktiviert werden kann, ohne dass die Bechichtungsquelle als solches abgeschaltet werden muss.

Zum Einbringen eines Prozessgases, z.B das Sputtergas Argon oder die Reaktivgase, N₂; O₂,C₂H₂ oder auch anderer Gas in die Prozesskammer 12 sind Mittel 15 vorgesehen, die im vorliegenden Fall eine absperrbare Zuleitung 15 ist. Das zu beschichtende Substrat 3 ist in der Prozesskammer auf einem nicht dargestellten Halter angeordnet und zum Anlegen einer Bias-Gleichspannung 16 oder einer RF-Spannung 16 mit einem Spannungsgeber verbunden.

Um die Funktionsweise der Beschichtungsvorrichtung 11 während der Durchführung eines erfindungsgemässen Beschichtungsverfahrens zu erläutern, wird im folgenden exemplarisch ein Beschichtungsprozess zur Beschichtung eines Werkzeugs 3 beschrieben, der für die Praxis von besonderer Bedeutung ist.

Nach dem das Werkzeug 3 in die Prozesskammer eingebracht worden ist, wird zunächst eine Erwärmung des Werkzeugs bei geschlossenen Blenden 131, die häufig auch als Shutter 131 bezeichnet werden, bevorzugt bei 250 - 800 °C durchgeführt. Dann erfolgt eine Ionenreinigung mit gepulster Vorspannung 16 (AAFP asymmetric alternating field pulsing) des Werkzeugs 3. Im nachfolgendem ersten Beschichtungsprozeß wird die Blende 131 der DC-Beschichtungsquelle 13, 1320 geöffnet und z.B. eine AlCrN-Verbundschicht 4 abgeschieden. Das Aufbringen der Verbundschicht 4 kann durch DC-Sputtern oder aber auch DC-Arc-Verdampfung erfolgen. Während der Abscheidung wird an das Werkstück 3 eine Bias-Spannung 16, bevorzugt eine negative Bias-Vorspannung 16 von ca. 10 - 400 V angelegt, es kann aber auch eine gepulste Vorspannung mit wechselnder Polarität (AAFP) eingesetzt werden. Die Frequenzen sind dann zum Beispiel im Bereich von 0,1 bis 300 KHz zu wählen, die positive Vorspannung liegt insbesondere im Bereich von 3 bis 100 V. Die Puls/Pausenverhältnisse können im Bereich von 0,1 bis 0,95 liegen.

Während des Abscheidens der Verbundschicht wird bereits das erste RF-Magnetron 1310 bei geschlossenem Shutter 131 aktiviert.

Anschließend wird der Sutter 131 geöffnet und je nach gewünschter Zwischenschicht ein Parallelbetrieb des DC-Magnetrons 13, 1320 und des RF-Magnetrons 1310 vorgenommen. Zur Einstellung eines Gradienten kann die Entladungsleistung der Magnetrons in geeigneter Weise verändert werden.

Dann wird die Blende 1303 der DC-Beschichtungsquelle 1320 geschlossen und die DC-Beschichtungsquelle für den Beschichtungsvorgang deaktiviert. Vorzugsweise wird nun bereits an das Substrat 3 eine RF-Spannung angelegt.

Die RF-Beschichtungsquelle 1310 dient zur Abscheidung einer SiCx Zwischenschicht 7. Sie ist mit einem Si-Target oder SiC-Target bestückt.

Während des Abscheidens der Zwischenschicht wird bereits das zweite RF-Magnetron 1300 bei geschlossenem Shutter 131 aktiviert.

Nach dem Erreichen der Zielschichtdicke wird in einem weiteren Schritt nun die Blende 131 der RF-Beschichtungsquelle 1300 geöffnet.

Je nach gewünschter Zwischenschicht in Form einer Gradientenschicht wird ein Parallelbetrieb des ersten RF-Magnetrons 1310 und des RF-Magnetrons 1300 vorgenommen. Zur Einstellung des Gradienten kann die Entladungsleistung der Magnetrons in geeigneter Weise verändert werden.

Dann wird die Blende 131 des RF-Magnetrons 1310 geschlossen und für den Beschichtungsvorgang deaktiviert.

Die RF-Beschichtungsquelle 1300 dient der Abscheidung z.B. einer SiBNC-Schicht als erste Hartschicht 5. Die RF-Beschichtungsquelle 1300 ist somit im vorliegenden Beispiel mit einem Target bestückt, das mindetens die Elemente SiB enthält, bevorzugt eine Mischung aus BN und SiC.

Die SiBNC-Beschichtungsquelle 1300 wird weiter betrieben um, eine SiBNC-Schicht als erste Hartschicht 5 auf der Gradienten-Mischschicht 8 abzusscheiden. In einem darauf folgenden Verfahrensschritt erfolgt die Zufuhr eines Prozessgases, z.B. von Sauerstoff durch die Zuleitung 15 in die Prozesskamer 12, bevorzugt die Zuführung von Sauerstoff zum Aufbringen beispielsweise einer SiBNCO-Schicht als Sauerstoff-Hartschicht 9, die dann die Deckschicht 10 bildet, wobei das erfindungsgemässe Beschichtungsverfahren z.B. so durchgeführt wird, dass der Sauerstoffanteil in der Sauerstoffhartschicht in Richtung vom Substrat 3 weg, also nach aussen zur Oberfläche hin zunimmt.

Bevorzugt können bei einem erfindungsgemässen Verfahren die zu beschichtenden Substrate auf eine Tempertaur von ca. 300 - 800 °C aufgeheitzt werden. Sodann wird nach Erreichen eines üblichen Startdruckes (ca. 0.01 Pa) eine Ionenreinigung z.B. mittels des AEGD-Processes durchgeführt. Der AEGD-Prozess ist dem Fachmann wohlbekannt und braucht daher hier nicht im Detail diskutiert zu werden. Für die Aufbringung der Schichten, insbesondere der Verbundschicht, wird das DC-Magnetron oder der Arc-Vakuumbogen-Verdampfer mit dem geeignetem Kathodenmaterial benutzt.

Es versteht sich dabei, dass in der Prozesskammer 12 auch nur 1 oder aber auch drei oder mehr RF-Beschichtungsquellen 13 oder auch mehr als eine DC-Beschichtungsquelle 13 vorgesehen sein kann, je nach Anwendung und je nach dem welche Schichtzusammensetzungen im Einzelnen gewünscht sind.

So kann das oben exemplarisch beschriebene erfindungsgemässe Verfahren auch zum Beispiel mit drei RF-Beschichtungsquellen 13 durchgeführt werden, wenn besondere Anforderungen auf die aufzubringenden Schichten bzw. deren chemische Zusammensetzung gestellt sind.

### Beispiel 1:

Beladung des Substrathalters mit Mikrowerkzeugen aus Hartmetall.
1) Erwärmung der Werkzeuge auf 500 °C.
2) Ionenreinigung ca. 30 min bei 200V gepulster Vorspannung, positive Spannung 30V, (20Khz),Puls/Pause 4, im AEGD-Prozess.
3) Abscheidung einer Al70Cr30-Schicht durch DC-Sputtern TARGET POWER5 W/cm2 , Vorspannung 50 V.
4) Reaktive Schichtabscheidung von AlCrN durch Zugabe von N (Stickstoff).
5) Metallische Zwischenschicht wie unter Punkt 3 angegeben.
6) Einschalten des RF-targets mt dem Mischungsverhältnis der atomaren Zusammenstzung Si:B 1 zu 6.
7) Zugabe von N O (Stickstoff, Sauerstoff) zur Abscheidung der Abschlussschicht.

### Beispiel 2:

1) Erwärmung der Werkzeuge auf 500 °C.
2) Ionenreinigung für ca. 30 min bei 200V gepulster Vorspannung, positive Spannung 30V, (20Khz),Puls/Pause 4, im AEGD-Prozess.
3) Abscheidung einer TiAlSiN-Schicht mittels der Vakuumbogenverdampfungsquelle.
4) Einschalten des RF-Targets mit einem Taget bestehend aus einer molaren Mischung BN plus SiC im Verhältnis 1 zu 1.
5) Zugabe von Stickstoff und Acetylen.
6) Zusätzliche Zugabe von Sauerstoff.

### Beispiel 3:

1) Erwärmung der Werkzeuge auf 500 °C.
2) Ionenreinigung für ca. 30 min bei 200V gepulster Vorspannung, positive Spannung 30V, (20Khz),Puls/Pause 4, im AEGD-Prozess.
3) RF-Sputtern von SiC.
4) Einlassen von N (Stickstoff).
5) Zuschalten des RF-Targets wie in Beispiel 2, Punkt 4).
6) Abschalten des SiC Targets.

Übliche Drücke, bei denen das Sputtern stattfindet, können dabei typischerweise im Bereich von 0.1 bis 5 Pa liegen.

Bei der Lichtbogenbeschichtung (Arc-Beschichtung) wird typisch mit einem Entladungsstrom von 30 - 200 A gearbeitet. Gängige Arc-Kathoden Durchmesser sind zum Beispiel ca.1 00 mm. Die Drücke, unter denen die Lichtbogenbeschichtung stattfindet liegen zum Beispiel im Bereich von 1 Pa bis 10 Pa.

## Patentansprüche

1. Schichtsystem zur Bildung einer amorphen Oberflächenschicht auf einer Oberfläche (2) eines Substrats (3), insbesondere auf der Oberfläche (2) eines Werkzeugs (3), wobei das Schichtsystem mindestens eine mittels PVD hergestellte Hartschicht (6) der Zusammensetzung SiₐB_{b}Me_{c}NᵤCᵥO_{w} mit a,b > 0 und 33 at% > c ≥0, bevorzugt 25 at% > c ≥0, im Speziellen 10 at% > c ≥0 und u,v,w ≥ 0 umfasst und Me ein Metall ist, **dadurch gekennzeichnet, dass** eine äussere Si-reiche Schicht auf der Oberfläche vorgesehen ist, durch die eine Sauerstoffdiffusion in die Schicht weitgehend verhindert ist, und die Härte des Schichtsystems zwischen 2000 und 3500 Vickers beträgt.

2. Schichtsystem nach Anspruch 1, wobei zusätzlich eine erste Hartschicht (5) aus SiₐB_{b}Me_{c}NᵤCᵥO_{w} vorgesehen ist, mit a,b > 0 und 33 at% > c ≥0, und u,v,w ≥ 0, und wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist.

3. Schichtsystem nach Anspruch 2, wobei w=0 ist und / oder wobei c= 0 ist.

4. Schichtsystem nach einem der vorangehenden Ansprüche, wobei ein Metallanteil im Schichtsystem unter 50at% eingestellt ist.

5. Schichtsystem nach einem der vorangehenden Ansprüche, wobei auf der Oberfläche (2) des Substrats (3) mindestens eine Verbundschicht (4), aus MeₓEyN_{z}, mit x > 0; y ≥ 0 und z > 0 vorgesehen ist, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist und E ein Element aus der Gruppe Si, B, C, O ist.

6. Schichtsystem nach einem der Ansprüche, wobei zwischen dem Substrat (3) und der Hartschicht (6) und / oder zwischen der Verbundschicht (4) und der Hartschicht (6) und / oder zwischen der ersten Hartschicht (5) und der Hartschicht (6) eine Zwischenschicht (7) umfassend die Elemente Si und / oder C vorgesehen ist.

7. Schichtsystem nach einem der vorangehenden Ansprüche, wobei zwischen dem Substrat (3) und der Hartschicht (6) und / oder zwischen der Verbundschicht (4) und der ersten Hartschicht (5) und oder zwischen der ersten Hartschicht (5) und der Hartschicht (6) eine Gradienten-Mischschicht (8) vorgesehen ist, die die Elemente Si und / oder C der Zwischenschicht (7) und die Zusammensetzung SiₐB_{b}Me_{c}NᵤCᵥO_{w}, der ersten Hartschicht (5) umfasst.

8. Schichtsystem nach einem der vorangehenden Ansprüche, wobei die Schichtdicke der Verbundschicht (4) und / oder der Zwischenschicht (7) und/ oder der Hartschicht (6) und / oder der ersten Hartschicht (5) und / oder der Gradienten-Mischschicht (8) und / oder der Deckschicht (10) zwischen 5 nm und 50000 nm, insbesondere zwischen 10 nm und 5000 nm, vorzugsweise zwischen 80 nm und 600 nm liegt.

9. Beschichtungsverfahren zum Aufbringen eines Schichtsystems (1) nach einem der Ansprüche 1 bis 8 auf eine Oberfläche (2) eines Substrats (3), insbesondere auf ein Werkzeug (3), in einer Prozesskammer (12) einer Beschichtungsvorrichtung (11) mit einer RF-Beschichtungsquelle (13) mit einem RF-Magnetron und / oder einer DC-Beschichtungsquelle (1320), insbesondere mit einem DC-Magnetron, wobei die RF-Beschichtungsquelle (13) und / oder die DC-Beschichtungsquelle (1320) durch eine Blende (131,) verschlossen werden kann, und Mittel (15) vorgesehen sind, so dass der Prozesskammer (12) ein Prozessgas zuführbar ist, und das Verfahren die folgenden Verfahrensschritte umfasst:
a.) Einbringen des Substrats (3) in die Prozesskammer (12);
b.) Erhitzen des Substrats (3) auf die Ionenreinigungstemperatur,
c.) Ionenereinigung des Substrats (3) bei der Ionenreinigungstemperatur;
d.) Abscheidung eines Schichtsystems (1) der Zusammensetzung SiₐB_{b}Me_{c}NᵤCᵥO_{w} mit a,b > 0 und 33 at% > c ≥0, bevorzugt 25 at% > c ≥0, im Speziellen 10 at% > c ≥0 und u,v,w ≥ 0, wobei Me ein Metall ist, unter Verwendung der RF-Beschichtungsquelle (13) und / oder der DC-Beschichtungsquelle (1320).

10. Beschichtungsverfahren nach Anspruch 9, umfassend die folgenden Verfahrensschritte:
a.) Einbringen des Substrats (3) in die Prozesskammer (12);
b.) Erhitzen des Substrats (3) auf eine Ionenreinigungstemperatur;
c.) Ionenereinigung des Substrats (3) bei der Ionenreinigungstemperatur und Anlegen einer Bias Gleichspannung (16) und / oder einer RF-Spannung (16) an das Substrat (3);
d.) Öffnen der Blende (1303) der DC-Beschichtungsquelle (1320) und / oder der Blende (1301) einer ersten RF-Beschichtungsquelle (1300);
e.) Abscheiden einer Verbundschicht (4) auf der Oberfläche (2) des Substrats (3), insbesondere einer Verbundschicht (4) aus MeₓEyN_{z}, mit x,y ≥ 0 und z > 0, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist und E ein Element aus der Gruppe Si, B, C, O st.
f.) Deaktivieren der DC-Beschichtungsquelle (1320) und / oder der ersten RF-Beschichtungsquelle (1300), Öffnen einer Blende (1302) einer zweiten RF-Beschichtungsquelle (1310) und in Betriebnahme der zweiten RF-Beschichtungsquelle (1310);
g.) Abscheiden einer Zwischenschicht (7) umfassend die Elemente Si und / oder C mittels der zweiten RF-Beschichtungsquelle (1310);
h.) Öffnen einer Blende einer dritten RF-Beschichtungsquelle, in Betriebnahme der dritten RF-Beschichtungsquelle und im Parallebetrieb mit der zweiten RF-Beschichtungsquelle (1310) Abscheidung von SiₐB_{b}Me_{c}NᵤCᵥO_{w}, insbesondere von SiₐB_{b}Me_{c}CᵥNᵤ, im speziellen von SiₐB_{b}CᵥNᵤ der ersten Hartschicht (5) mittels der zweiten RF-Beschichtungsquelle zur Bildung einer Gradienten-Mischschicht (8);
i.) Deaktivieren der zweiten RF-Beschichtungsquelle (1310) und Abscheiden einer ersten Hartschicht (5) aus SiₐB_{b}Me_{c}NᵤCᵥO_{w}, insbesondere SiₐB_{b}Me_{c}CᵥNᵤ, im speziellen SiₐB_{b}CᵥNᵤ beim Weiterbetrieb der dritten RF-Beschichtungsquelle bis zu einer vorgegebenen Beschichtungsdicke der ersten Hartschicht (5);
j.) Zugabe eines Reaktivgases, insbesondere Sauerstoff, Stickstoff oder ein Kohlenstoff enthaltendes Gas, in die Prozesskammer (12) und Bildung einer Sauerstoff-Hartschicht (9) mit der Zusammensetzung SiₐB_{b}Me_{c}NᵤCᵥO_{w}.

11. Beschichtungsverfahren nach einem der Ansprüche 9 oder 10, wobei die DC-Beschichtungsquelle (1320) und / oder die RF-Beschichtungsquelle (13) eine Sputterquelle und / oder eine Lichtbogen-Verdampfungsquelle ist.

12. Beschichtungsverfahren nach einem der Ansprüche 9 bis 11, wobei der Beschichtungsvorgang mittels eines PVD-Verfahrens, bevorzugt mittels RF-Sputtern und / oder DC-Sputtern und oder mittels Ionenimplantation und / oder mittels Laserablation und /oder mittels einem Lichtbogenverdampfungsverfahren, insbesondere mittels einem kathodischen und / oder anodischen Lichbogenverdampfungsverfahren durchgeführt wird.

13. Substrat, insbesondere Werkzeug (3), beschichtet mit einem Schichtsystem (1) nach einem der Ansprüche 1 bis 8 und aufgebracht mit einem Verfahren nach einem der Ansprüche 9 bis 12.

14. Werkzeug nach Anspruch 13, wobei das Werkzeug ein spanendes Werkzeug (3), insbesondere ein Bohrer (3), ein Fräser (3), eine Wendeschneidplatte (3) für einen Dreh- oder Fräsprozess oder ein Hobelwerkzeug (3), ein Umformwerkzeug (3) oder ein Mikrowerkzeug (3), insbesondere ein Mikrobohrer (3), eine Mikrowendeschneidplatte (3), ein Mikrofräser (3) oder ein anderes Werkzeug (3) oder Mikrowerkzeug (3) oder ein Kunststoffwerkzeug (3) ist.

15. Substrat nach Anspruch 13, wobei das Substrat ein Verschleissteil (3), insbesondere ein Verschleissteil (3) für eine Luft- oder Land gestützte Turbine, einen Motor, im Speziellen für einen Verbrennungsmotor, im speziellen eine Dichtung (3), ein Zahnrad (3), ein Kolben (3) oder ein anderes Verschleissteil (3) ist.
